Europäisches Patentamt

European Patent Office

Office européen des brevets

(19)

(11) Publication number: **0 058 998**
**B1**

(12) **EUROPEAN PATENT SPECIFICATION**

(45) Date of publication of patent specification: **27.12.84**

(21) Application number: **82102731.5**

(22) Date of filing: **24.01.80**

(60) Publication number of the earlier application in accordance with Art. 76 EPC: **0 014 388**

(51) Int. Cl.³: **G 11 C 11/34, H 01 L 29/78, H 01 L 27/10**

(54) **Semiconductor memory device.**

(30) Priority: **25.01.79 JP 7988/79**

(43) Date of publication of application:
**01.09.82 Bulletin 82/35**

(45) Publication of the grant of the patent:
**27.12.84 Bulletin 84/52**

(84) Designated Contracting States:
**DE FR GB IT NL**

(56) References cited:
**FR-A-2 358 026**
**FR-A-2 381 373**
**FR-A-2 394 143**

**NEUES AUS DER TECHNIK, vol.1978, no.5, October 16, 1978, WUERBURG (DE) "Verbesserung der Eingangskennlinie einer PCCD", page 2**

(73) Proprietor: **NEC CORPORATION**
**33-1, Shiba 5-chome, Minato-ku**
**Tokyo 108 (JP)**

(72) Inventor: **Hamano, Kuniyuki**
**c/o Nippon Electric Co., Ltd. 33-1 Shiba Gochome**
**Minato-ku Tokyo (JP)**
Inventor: **Ohta, Toshiyuki**
**c/o Nippon Electric Co., Ltd. 33-1, Shiba-Gochome**
**Minato-ku Tokyo (JP)**

(74) Representative: **Glawe, Delfs, Moll & Partner**
**Patentanwälte**
**Postfach 26 01 62 Liebherrstrasse 20**
**D-8000 München 26 (DE)**

Courier Press, Leamington Spa, England.

# Description

The present invention relates to a semiconductor memory device that can be realized in the form of an integrated circuit. More particularly, the invention relates to a semiconductor memory device comprising a semiconductor substrate of a first conductivity type, first and second semiconductor regions of a second conductivity type provided in said semiconductor substrate, a channel region positioned between said first and second semiconductor regions at the surface of said semiconductor substrate, an insulator film disposed on said channel region, a control electrode disposed on said insulator film, means for generating depletion layers from said first and second semiconductor regions in such a manner that said depletion layers contact with each other to isolate at least a portion of said channel region from said substrate in vertical direction of said semiconductor substrate, means for operatively accumulating majority carriers to said channel region at a density higher than that of said semiconductor substrate, means for operatively withdrawing majority carriers from said channel region, and means for detecting the existence of the accumulation of said majority carriers in said channel region.

A memory device of this type has been known from FR—A—2 394 143. Such a memory device can be advantageously used in a RAM memory in which the stored information is represented by the presence or absence of the majority carriers at the channel region. Writing of different logical information is performed by operatively accumulating and withdrawing, or injecting and depleting, the majority carriers into and from the channel region. It is hereby possible to trap a relative high charge, causing sufficient potential change between the logic "0" and "1" states, in memory cells having a low capacitance and thus requiring small chip space.

In the memory device according to the aforementioned prior art document, the majority carriers are injected into the channel region from the substrate, whereby a depletion layer is formed in the substrate below the channel region, and they are withdrawn from the channel region into the substrate. This requires movement of the majority carriers vertically, i.e. at right angles to the plane of the substrate, and through the depletion layer. The speed of movement of the majority carriers is thus limited by the low conductivity of the depletion layer and by the difficulty of obtaining a large potential gradient between the substrate and the channel region through that depletion region. It is difficult with this memory device to transfer a large amount of majority carriers at high speed. Additionally, three different potentials at a control electrode are required for controlling the writing and holding operations.

It is an object of the present invention to provide a semiconductor memory device of the abovementioned kind wherein the accumulation and withdrawal of the majority carriers can be performed with high speed and which has a more simple, easy and stable control of the writing, reading and holding operations.

According to the invention, a semiconductor memory device of the aforementioned kind is characterized in that a third semiconductor region of said first conductivity type is formed in one of said first and second semiconductor regions, and that said third semiconductor region forms part of both of said accumulating means and said withdrawing means.

With such a memory device according to the invention, the accumulation and withdrawal of majority carriers is not from or to the substrate, and accordingly it is not necessary to use varying potential gradients in the substrate, and therefore the state of depletion regions in the substrate will not be changed in the various operations. Majority carriers can be transferred from and to the additional semiconductor region at high speed and with an easy and stable control resembling a bipolar transistor operation.

From "Neues aus der Technik", Vol. 1978, No. 5, article 485, it has in principle been known to provide an additional semiconductor region for the purpose of injecting charge carriers into another semiconductor region. This prior art, however, relates to charge coupled device for analog signal processing and has an operation different from a memory device according to the present invention.

In accordance with a preferred embodiment of the invention one of said first and second semiconductor regions is formed in a ring-shape pattern and the other of said first and second semiconductor regions is formed in an island pattern surrounded by said ring-shape pattern. Similar ring-shape patterns have in principle been known from IEEE Journal of Solid State Circuits, Vol. SC-12, No. 4, August 1977, pages 344—348.

The semiconductor memory device according to the present invention can be advantageously used in connection with punch-through readout of the information contained in the memory cell. This is claimed in the parent case 80 10 0359.1, granted as European patent No. 0 014 388, and the use of punch-through readout by the means for detecting the existence of the accumulation of majority cameo is therefore disclaimed in the present case.

Preferred embodiments of the invention will be described with reference to the accompanying drawings, wherein

Fig. 1 is a cross-section view showing a memory cell according to one preferred embodiment of the present invention,

Fig. 2 is a cross-sectional view showing a first modification of memory cell in Fig. 1,

Fig. 3 is a cross-sectional view showing a second modification of the memory cell in Fig. 1,

Fig. 4 is a schematic circuit diagram showing a memory circuit composed of the memory cells illustrated in Fig. 1,

Figs. 5(A) to 5(F) are schematic cross-sectional views to be used for explaining the operation of the memory cell in Fig. 3.

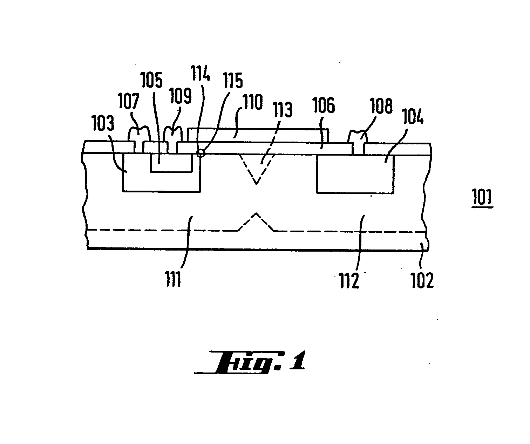

Now one preferred embodiment of the present invention will be described with reference to Fig. 1.

The illustrated memory cell has the struture comprising a high-resistance P-type silicon substrate 102, a source 103 and a drain 104 each consisting of a square-shaped N-type layer, a P-type layer 105 formed within the source 103 and deviating towards the drain 104, a gate insulating film 106, a gate electrode 110, and metal electrodes 107, 108, and 109 and connected respectively to the source 103, drain 104, and P-type layer 105. In this example, for the P-type substrate 102 a silicon substrate having an impurity concentration of $3 \times 10^{14}/cm^3$ is employed, and for the gate insulating film 106 a silicon oxide film of 1000Å in thickness is used. The drain region 103 and source region 104 are formed by selective diffusion or ion implantation of phosphorus, the depth of junction being $2.0\mu$, and the impurity concentration is $10^{19}/cm^3$. The distance between the drain region 103 and the source region 104, that is, the effective channel length is selected to be $3.0\mu$. The P-type layer 105 has an impurity concentration of $10^{21}/cm^3$ and a junction depth of $1\mu$. Under such conditions, a built-in potential $V_{bi}$ at the PN-junctions formed between the drain region 103 and the substrate 102 and between the source region 104 and the substrate 102 is about 0.7V. Accordingly the width W of depletion layers 111 and 112 produced by this built-in potential $V_{bi}$ is equal to $1.7\mu$, because the width W of the depletion layers 111 and 112 are represented as a function of the built-in potential $V_{bi}$ in the following form:

$$W = \frac{2\varepsilon_s V_{bi}}{\phi N_B}^{1/2}$$

where $N_B$ represents a concentration of a substrate, $\phi$ a charge of the electron, and $\varepsilon_s$ a dielectric constant of silicon. Owing to this internal potential, the depletion layers 111 and 112 can be brought into contact with each other, and a pocket region surrounded by the depletion layers 111 and 112 can be produced in the channel region 113.

In order to use such a MOS transistor structure 101 as a memory cell, it is necessary to accumulate or deplete positive holes, which are the majority carrier in the substrate 102, in the channel region 113 surrounded by the depletion layer 111 extending from the source 103 and the depletion layer 112 extending from the drain 104. Now for the purpose of accumulating positive holes in the channel region 113, at first a negative potential is applied to the gate electrode 110 to establish the state where the positive holes forming the majority carriers can be captured in the channel region 113 and to raise the potential at the surface 114 of the source 103 located between the P-type impurity layer 105 and the depletion layer 111. When a positive potential is applied to the electrode 109 at the same time, positive holes are injected from the P-type impurity layer 105 into the channel region 113. On the other hand, for the purpose of depleting positive holes in the channel region 113, when the negative potential is applied to the gate electrode 110, a negative potential is applied to the electrode 109 to raise the potential of the source 103 and thereby make the positive holes flow out at the channel region 113 to the P-type region 105. Such states of the channel region 113 where positive holes are accumulated or depleted can be held for several seconds to several tens seconds due to the fact that the channel region 113 is electrically insulated from the interior of the substrate 102 because it is surrounded by the depletion layers 111 and 112. Accordingly, in order to sustain such states of the channel region 113, it is only necessary to carry our similar writing again, that is, to effect refresh within the holding time.

Whether positive holes are accumulated or depleted in the channel region 113 can be detected by applying a positive voltage to the gate electrode 110 and a fairly large positive voltage to the drain 104. More particularly, since the MOS transistor structure 101 forming the memory cell according to the present invention has such impurity concentration of the substrate 102 and such distance between the source 103 and the drain 104 that the depletion layers 111 and 112 are contiguous to each other under the condition where no voltage is applied to the substrate 102, source 103 and drain 104, when a certain positive voltage is applied to the drain 104 and the gate electrode 110, the depletion layer 112 extending from the drain side further extends largely until it reaches the source 103, and thus the so-called punch-through current flows. This punch-through current, which, as noted above, does not form part of the presently claimed invention, is produced by injection of electrons from the source 103, and at a certain positive drain voltage, this electron injection can be made to occur only at the surface portion 115 of the PN-junction between the source 103 and the substrate 102 by applying a positive voltage to the gate electrode 110. When the punch-through occurs only at the surface portion as described above, whether positive holes are accumulated or not in the channel region 113 largely affects the punch-through current flowing between the source 103 and the drain 104, and under the condition where positive holes are not excessively accumulated the punch-through current flows largely, whereas under the condition where positive holes are accumulated the punch-through current is small or the punch-through does not occur. Accordingly, if whether positive holes are accumulated or not in the channel region 113 is made to correspond to the information of "0" or "1", then the direction of the stored information can be effected by means of the source-drain current that is made to flow by the punch-through. The source-drain current can be chosen very large, so that it becomes possible to make the potential on the bit line largely change as compared to the method in which a charge stored in a capacitor is redistributed on a bit line and the potential change on the bit line is observed as is seen in the heretofore known one-transistor dynamic memories.

Therefore, the above-described memory has a great advantage that even if the memory is enlarged to a large-capacity memory and thereby a bit line capacitance is increased, detection of the stored information is made sufficiently possible. Moreover, in the memory cell according to the present invention, since the accumulated carriers are not directly read out but the stored information is detected by the intermediary of the source-drain current modulated by the accumulated carriers, a large capacitor for accumulating the carriers is not necessitated, and therefore, the above-described memory has another advantage that the memory circuit is suitable for a high degree of circuit integration.

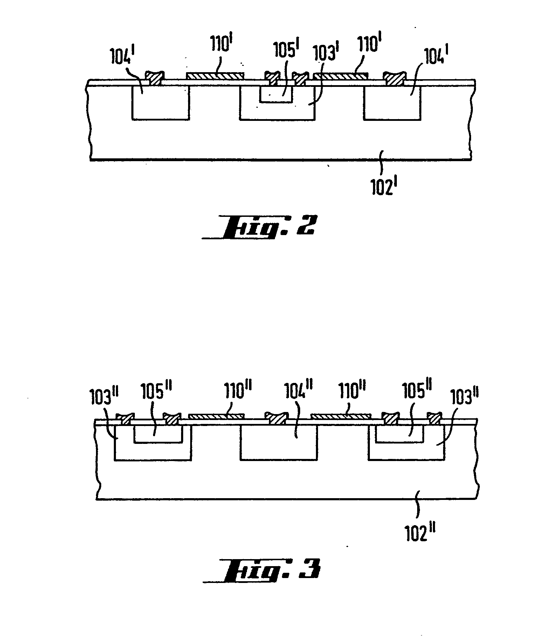

In Fig. 2 is illustrated one preferable modification of the memory cell shown in Fig. 1. In this modification, a drain region 104' is formed in a ring shape or in a square frame shape, nearly at the center of the portion of a semiconductor substrate 102' surrounded by the ring-shaped or frame-shaped drain region 104' are formed an island-shaped source region 103' and a P-type impurity layer 105' within the source region 103', and on a ring-shaped or frame-shaped channel region between these drain region 104' and source region 103' is provided a ring-shaped or frame-shaped gate electrode 110'. Since a pocket region surrounded by depletion layers produced such shape of source region 103' and drain region 104' is completely enclosed by the depletion layers, the characteristics of holding the existence state of majority carriers of the pocket region can be improved.

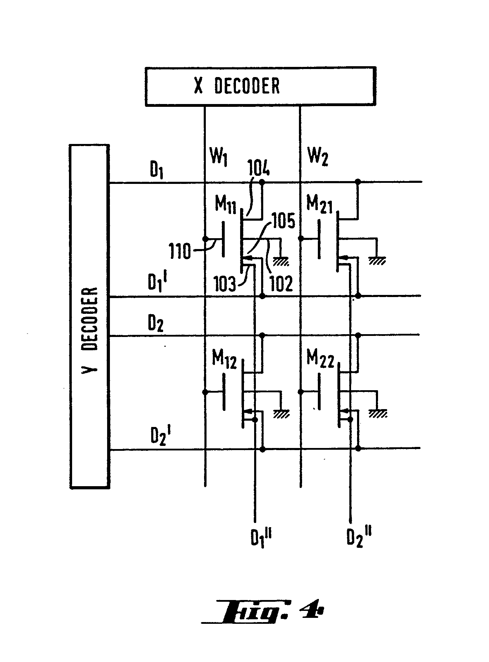

In Fig. 3 is illustrated a second preferable modification of the memory cell shown in Fig. 1. In this modification, a source region 103" and a P-type impurity layer 105" are formed in an annular shape so as to surround an island-shaped drain region 104". In this modification, similarly to the first modification illustrated in Fig. 2, the existence state of majority carriers in the channel region can be better held. Furthermore, since the P-type impurity layer 105" is also formed in an annular shape, injection of majority carriers from the P-type impurity layer 105" to the channel region also can be achieved at a high speed.

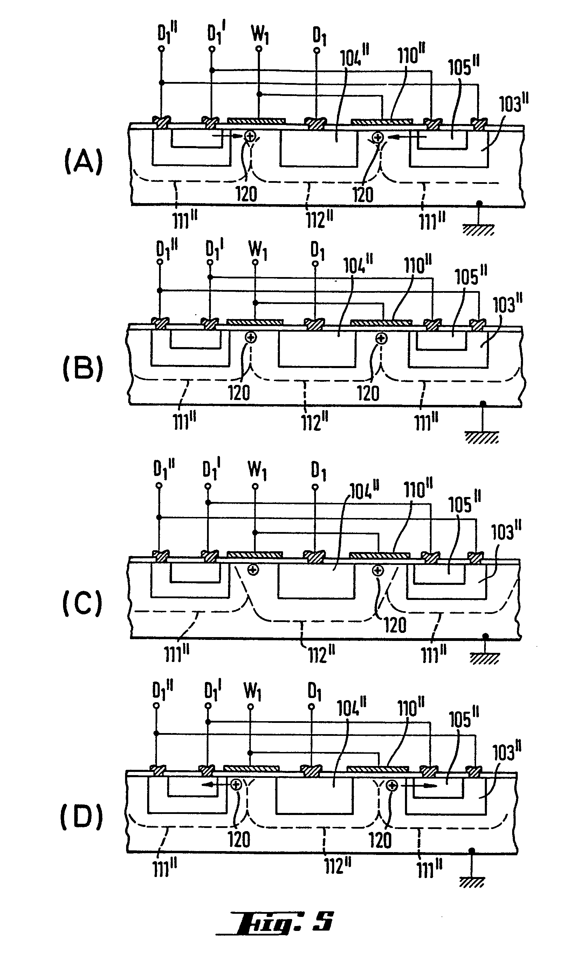

Now description will be made on a memory composed of the memory cells 101 illustrated in Fig. 1 (or Fig. 2 or 3) with reference to Fig. 4. If this figure, by way of example, a $2 \times 2$ matrix construction is illustrated. In Fig. 4, word lines $W_1$ and $W_2$ are connected to gates 110 (110', 110") of memory cells 101, read digit lines $D_1$ and $D_2$ are connected to drains 104 (104', 104") of the same, and write digit lines $D_1'$ and $D_2'$ are connected to impurity diffused layers 105 (105', 105") within sources 103 (103', 103"). Here, substrates 102 of all the cells are grounded in common. The source 103 (103', 103") is connected to an auxiliary digit line $D_1''$.

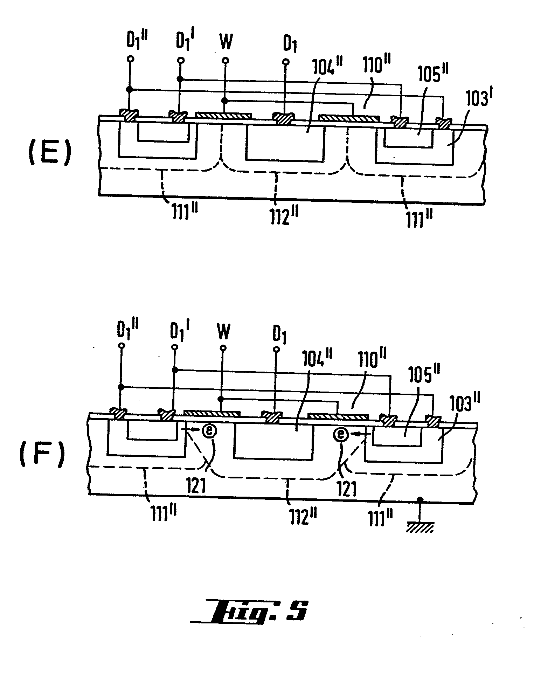

Next, the operation of the matrix construction composed of the memory cells shown in Fig. 3 as illustrated in Fig. 4, will be described particularly in connection to one memory cell $M_{11}$, with reference to Fig. 5. Here it is assumed that the impurity concentrations of the respective regions and the substrate and the dimensions of the respective portions fulfil the same conditions as the first preferred embodiment shown in Fig. 1.

At first, the operation upon writing a "0" in the memory cell will be described. At first the word line $W_1$ is held at a negative potential of $-3V$, and the write digit line $D_1'$ is brought to $+3V$. While the drain 104" is held at the ground level. Under such condition, positive holes 120 as the majority carriers are injected from the P-type impurity layer 105" to the channel region as shown in Fig. 5(A). In this way, the positive holes 120 are accumulated in the channel region at an excessive degree, and thereby writing of the information "0" is effected.

After writing of this information "0", the word line $W_1$, the read digit line $D_1$ and the write digit line $D_1'$ are held at the ground potential, so that the positive holes 120 are retained in the channel region as shown in Fig. 5(B).

Subsequently, when the information "0" stored in this memory cell $M_{11}$ is to be read out, the word line $W_1$ is changed in potential to $+1V$, and the read digit line $D_1$ is changed in potential to $+3V$. At this moment, the write digit line $D_1'$ is held grounded. Then, as shown in Fig. 5(C), in this case, the positive holes are excessively present in the channel region, the punch-through current, which as noted above does not form part of the presently claimed invention, is not provided.

Next, write-read operations of the information "1" will be described. Then the word line $W_1$ is brought to a positive potential of about $-3V$, while the write digit line $D_1'$ is brought to $-3V$. At this moment, as shown in Fig. 5(D), the positive holes 120 in the channel region are swept out through the P-type impurity region 105", so that the channel region takes a depletion state of majority carriers and thereby storage of the information "1" is effected. During this write period, in the other memory cells $M_{12}$, $M_{21}$ and $M_{22}$ the information stored previously therein can be preserved because either the write digit line $D_2'$ is held at the ground level or the word line $W_2$ is held at the ground potential. Subsequently, when the write operation has finished, the applied potential condition is held the same as that in Fig. 5(B), and hence, the information represented by the depletion of the majority carriers is retained as shown in Fig. 5(E). Next, when it is intended to read the information "1" stored in this memory cell $M_{11}$, the read operation is conducted by establishing the same potential condition as that shown in Fig. 5(C), that is, by holding the word line $W_1$ at the +1V level and the read digit line $D_1$ at +3V level. In this case the depletion layer 112″ extending from the drain region 104″ reaches the source region 103″, so that electrons 121 are injected from the source region 103″ into the depletion layer 112″ and thereby a punch-through current, which as noted above does not form part of the presently claimed invention, is produced between the source and the drain. Detection of the information "1" stored in this memory cell $M_{11}$ can be effected by sensing the punch-through current which flows through the read digit line $D_1$. In the other memory cells $M_{12}$, $M_{21}$ and $M_{22}$, the previously written information can be preserved, because the read digit line $D_2$ is held at the ground potential or the word line $W_2$ is held at the ground potential. In addition, re-write (refresh) of the information in the memory cell $M_{11}$ is effected only by detecting the read current through the read digit line $D_1$ and writing the signal corresponding to the read current in the same memory cell $M_{11}$.

While the present invention has been described above in connection to its preferred embodiments, it is a matter of course that the invention should not be limited only to the illustrated embodiments but it can be realized in various forms under various conditions of an impurity concentration and under various voltage conditions. In addition, while the channel region is isolated from the substrate by the depletion layers produced by the built-in potential in the above-described embodiments, the channel region may be isolated by producing depletion layers by an external electric field.

## Claims

1. A semiconductor memory device comprising a semiconductor substrate (102) of a first conductivity type, first and second semiconductor regions (103, 104) of a second conductivity type provided in said semiconductor substrate, a channel region (113) positioned between said first and second semiconductor regions at the surface of said semiconductor substrate, an insulator film (106) disposed on said channel region, a control electrode (11) disposed on said insulator film, means for generating depletion layers (111, 112) from said first and second semiconductor regions in such a manner that said depletion layers contact with each other to isolate at least a portion of said channel region from said substrate in vertical direction of said semiconductor substrate, means for operatively accumulating majority carriers to said channel region at a density higher than that of said semiconductor substrate, means for operatively withdrawing majority carriers from said channel region, and means for detecting the existence of the accumulation of said majority carriers in said channel region, characterized in that a third semiconductor region (105) of said first conductivity type is formed in one of said first and second semiconductor regions, and that said third semiconductor region (105) forms part of both of said accumulating means and said withdrawing means.

2. The device according to claim 1, characterized in that one of said first and second semiconductor regions is formed in a ring-shape pattern and the other of said first and second semiconductor regions is formed in an island pattern surrounded by said ring-shape pattern.

## Patentansprüche

1. Halbleiterspeicheranordnung mit einem Halbleitersubstrat (102) von einem ersten Leitfähigkeitstyp, einem ersten und einem zweiten Halbleiterbereich (103, 104) von einem zweiten Leitfähigkeitstyp, die in dem Halbleitersubstrat vorgesehen sind, einem Kanalbereich (113), der zwischen dem ersten und dem zweiten Halbleiterbereich auf der Oberfläche des Halbleitersubstrats angeordnet ist, einer Isolatorschicht (106), die auf dem Kanalbereich angeordnet ist, einer Steuerelektrode (110), die auf der Isolatorschicht angeordnet ist, einer Vorrichtung zur Erzeugung von Verarmungsschichten (111, 112) von dem ersten und dem zweiten Halbleiterbereich in einer Weise, daß die Verarmungsschichten sich berühren, um zumindest einen Teil des Kanalbereiches in vertikaler Richtung des Halbleitersubstrats vom Substrat zu isolieren, eine Vorrichtung zum wirksamen Akkumulieren von Majoritätsträgern im Kanalbereich mit einer Dichte größer der des Halbleitersubstrats, einer Vorrichtung zum wirksamen Abziehen von Majoritätsträgern aus dem Kanalbereich, und einer Vorrichtung zum Feststellen der Existenz einer Akkumulation von Majoritätsträgern im Kanalbereich, dadurch gekennzeichnet, daß ein dritter Halbleiterbereich (105) des ersten Leitfähigkeitstyps im ersten oder zweit Halbleiterbereich ausgebildet ist, und daß der dritte Halbleiterbereich (105) einen Teil Der Akkumulationsvorrichtung und der Abzugsvorrichtung bildet.

2. Halbleiterspeicheranordnung nach Anspruch 1, dadurch gekennzeichnet, daß der erste oder der zweite Halbleiterbereich ringförmig ausgebildet ist, und daß der zweite oder der erste Halbleiterbereich inselförmig ausgebildet ist und von der Ringform umgeben ist.

## Revendications

1. Dispositif semi-conducteur à mémoire comprenant un substrat semi-conducteur (102) d'un premier type de conductibilité, des première et seconde régions à semi-conducteur (103, 104) d'un second type de conductibilité prévues sur le substrat semi-conducteur, une région à canal (113) placée entre les première et seconde régions à semi-conducteur à la surface du substrat semi-conducteur, une pellicule d'isolant (106) disposé sur la région à canal, une électrode de commande (11) disposée sur la pellicule d'isolant, un moyen pour produire des couches d'épuisement (111, 112) à partir des première et seconde régions à semi-conducteur d'une manière telle que les couches d'épuisement sont en contact l'une avec l'autre afin d'isoler au moins une partie de la région à canal du substrat dans la direction verticale du substrat semi-conducteur, un moyen pour accumuler de manière opérative des porteurs majoritaires dans la région à canal à une densité supérieure à celle du substrat semi-conducteur, un moyen pour opérativement extraire des porteurs majoritaires de la région à canal, et un moyen pour détecter l'existence de l'accumulation des porteurs majoritaires dans la région à canal, caractérisé en ce qu'une troisième région à semi-conducteur (105) du premier type de conductibilité est formée dans l'une des première et seconde régions à semi-conducteur, et en ce que la troisième région à semi-conducteur (105) fait partie du moyen d'accumulation ainsi que du moyen d'extraction.

2. Dispositif selon la revendication 1, caractérisé en ce que l'une des première et seconde régions à semi-conducteur est réalisée suivant un motif en forme d'anneau et l'autre des première et seconde régions à semi-conducteur se présente sous forme d'une île entourée par le motif en forme d'anneau.

**Fig. 1**

**Fig. 2**

**Fig. 3**

*Fig. 4*

**0 058 998**

Fig. 5

Fig. 5